(19) Europäisches Patentamt
European Patent Office
Office européen des brevets

(11) **EP 3 854 767 A1**

(12) **EUROPEAN PATENT APPLICATION**
published in accordance with Art. 153(4) EPC

(43) Date of publication:
**28.07.2021 Bulletin 2021/30**

(51) Int Cl.:
**C04B 35/119** (2006.01)  **H01L 23/15** (2006.01)

(21) Application number: **18942630.7**

(86) International application number:
**PCT/JP2018/044950**

(22) Date of filing: **06.12.2018**

(87) International publication number:
**WO 2020/115870 (11.06.2020 Gazette 2020/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **NGK Insulators, Ltd.**
**Nagoya-shi, Aichi 467-8530 (JP)**

• **NGK Electronics Devices, Inc.**
**Mine-shi, Yamaguchi 759-2212 (JP)**

(72) Inventors:
• **UMEDA, Yuji**
**Mine-shi, Yamaguchi 759-2212 (JP)**
• **KOUNO, Hiroshi**
**Mine-shi, Yamaguchi 759-2212 (JP)**

(74) Representative: **Müller-Boré & Partner**
**Patentanwälte PartG mbB**
**Friedenheimer Brücke 21**
**80639 München (DE)**

(54) **CERAMIC SINTERED BODY AND SUBSTRATE FOR SEMICONDUCTOR DEVICES**

(57) The ceramic sintered body (3) contains Zr, Al, Y, and Mg, and the Zr content is 7.5 mass% or more and 23.5 mass% or less in terms of $ZrO_2$, the Al content is 74.9 mass% or more and 91.8 mass% or less in terms of $Al_2O_3$, the Y content is 0.41 mass% or more and 1.58 mass% or less in terms of $Y_2O_3$, and the Mg content is 0.10 mass% or more and 0.80 mass% or less in terms of MgO. The M phase ratio of the ceramic sintered body (3) after thermal aging is 15% or less.

FIG. 1

EP 3 854 767 A1

**Description**

TECHNICAL FIELD

The present invention relates to a ceramic sintered body and a substrate for a semiconductor device.

BACKGROUND ART

As a substrate for a semiconductor device used for a power transistor module or the like, a DBOC substrate (Direct Bonding of Copper Substrate) including a copper plate on the surface of a ceramic sintered body or a DBOA substrate (Direct Bonding of Aluminum Substrate) including an aluminum plate on the surface of a ceramic sintered body is known.

PATENT LITERATURE 1 discloses a ceramic sintered body containing alumina, partially stabilized zirconia, and magnesia. In the ceramic sintered body described in PATENT LITERATURE 1, the content of partially stabilized zirconia is 1 to 30 wt%, and the content of magnesia is 0.05 to 0.50 wt%. The molar fraction of yttria in partially stabilized zirconia is 0.015 to 0.035, and 80 to 100% of the zirconia crystals contained in the ceramic sintered body are tetragonal phases. The ceramic sintered body described in PATENT LITERATURE 1 is supposed to be capable of improving the mechanical strength and preventing cracks and voids (partial peeling or floating) from occurring at the bonding interface between the ceramic sintered body and the copper plate or the aluminum plate.

PATENT LITERATURE 2 discloses a ceramic sintered body containing alumina, zirconia, and yttria. In the ceramic sintered body described in PATENT LITERATURE 2, the content of zirconia is 2 to 15 wt%, and the average particle size of alumina is 2 to 8 $\mu$m. The ceramic sintered body described in PATENT LITERATURE 2 is supposed to be capable of improving the thermal conductivity.

PATENT LITERATURE 3 discloses a ceramic substrate containing alumina, a stabilizing component, hafnia and zirconia. In the ceramic substrate described in PATENT LITERATURE 3, the weight ratio of hafnia and zirconia to alumina is 7 to 11 weight ratio, and the average particle size of alumina is 1.0 to 1.5 $\mu$m, and the average particle size of zirconia is 0.3 to 0.5 $\mu$m. The ceramic sintered body described in PATENT LITERATURE 3 is supposed to be capable of improving the thermal conductivity.

Citation List

Patent Literature

   [Patent Literature 1] JP 4717960B
   [Patent Literature 2] JP 2015-534280A
   [Patent Literature 3] WO 2016-208766

SUMMARY

Technical Problem

However, in the ceramic sintered bodies described in PATENT LITERATURE 1, PATENT LITERATURE 2, and PATENT LITERATURE 3, in addition to the problem that the mechanical strength is likely to decrease when exposed to a high temperature environment, there is also a problem that cracks are likely to occur, when the thermal cycle is repeated in a state of being incorporated in a substrate for a semiconductor device.

An object of the present invention is to provide a ceramic sintered body capable of preventing a decrease in mechanical strength and a generation of cracks.

Solution to Problem

The ceramic sintered body according to the present invention contains Zr, Al, Y, and Mg, and the Zr content is 7.5 mass% or more and 23.5 mass% or less in terms of $ZrO_2$, the Al content is 74.9 mass% or more and 91.8 mass% or less in terms of $Al_2O_3$, the Y content is 0.41 mass% or more and 1.58 mass% or less in terms of $Y_2O_3$, and the Mg content is 0.10 mass% or more and 0.80 mass% or less in terms of MgO. The ceramic sintered body contains a $ZrO_2$ crystal phase as a crystal phase. The $ZrO_2$ crystal phase has a monoclinic phase and a tetragonal phase as crystal structures. When the thermal aging treatment is performed for 100 hours in an environment of 180 degrees C, the ratio of the peak intensity of the monoclinic phase to the sum of the peak intensities of the monoclinic phase and the tetragonal phase is 15% or less in the X-ray diffraction pattern.

Advantageous Effects of Invention

According to the present invention, it is possible to provide a ceramic sintered body capable of preventing a decrease in mechanical strength and an occurrence of cracks.

BRIEF DESCRIPTION OF DRAWINGS

FIG. 1 is a cross-sectional view showing a configuration of a semiconductor device according to an embodiment.
FIG. 2 is a flowchart for explaining a method of manufacturing a substrate for a semiconductor device according to an embodiment.
FIG. 3 is a cross-sectional view showing the configuration of a substrate sample for a semiconductor device according to an embodiment.

DESCRIPTION OF EMBODIMENTS

Hereinafter, the configuration of a ceramic sintered body according to the present invention and a substrate for a semiconductor device using the same will be described with reference to the drawings.

(Structure of semiconductor device 1)

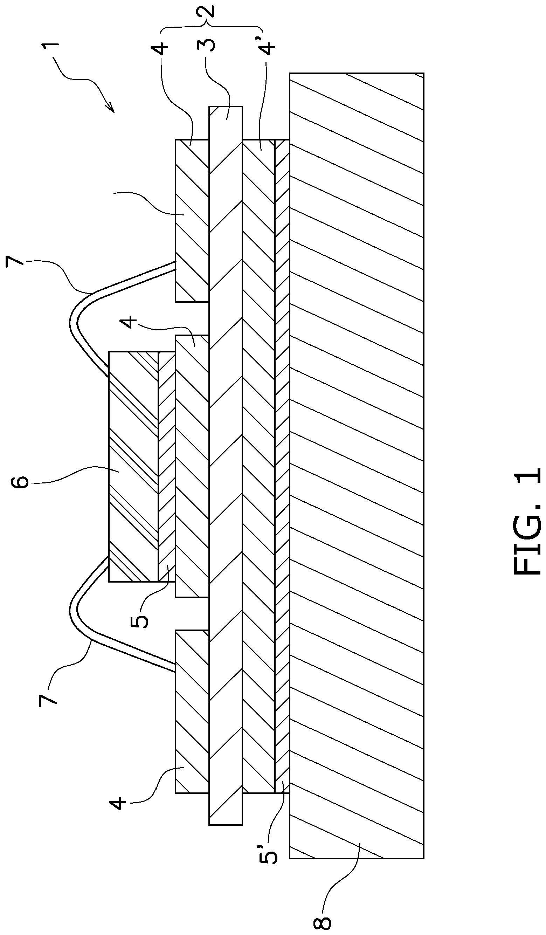

FIG. 1 is a cross-sectional view of a semiconductor device 1 according to the embodiment. The semiconductor device 1 is used as power module in various electronic devices such as an automobile, an air conditioner, an industrial robot, a commercial elevator, a household microwave oven, an IH electric rice cooker, power generation (wind power generation, solar power generation, fuel cell, or the like), electric railway, UPS (uninterruptible power supply) or the like.
The semiconductor device 1 includes a semiconductor device substrate 2, a first bonding material 5, a second bonding material 5', a semiconductor chip 6, a bonding wire 7, and a heat sink 8.
The semiconductor device substrate 2 is a so-called DBOC substrate (Direct Bonding of Copper Substrate). The semiconductor device substrate 2 includes a ceramic sintered body 3, a first copper plate 4, and a second copper plate 4' .
The ceramic sintered body 3 is an insulator for the semiconductor device substrate 2. The ceramic sintered body 3 is formed in a flat plate shape. The ceramic sintered body 3 is a substrate of the semiconductor device substrate 2. The configuration of the ceramic sintered body 3 will be described later.
The first copper plate 4 is bonded to the surface of the ceramic sintered body 3. A transmission circuit is formed on the first copper plate 4. The second copper plate 4' is bonded to the back surface of the ceramic sintered body 3. The second copper plate 4' is formed in a flat plate shape.
Note that the semiconductor device substrate 2 may be a so-called DBOA substrate (Direct Bonding of Aluminum Substrate) using first and second aluminum plates instead of the first and second copper plates 4 and 4' . In a DBOA substrate using an aluminum plate softer than a copper plate, it is possible to further relax the thermal stress generated inside.
The first copper plate 4 on which a transmission circuit is formed is bonded to the surface of the ceramic sintered body 3 in the semiconductor device substrate 2. The transmission circuit may be formed by a subtractive method or an additive method.
The method for manufacturing the semiconductor device substrate 2 is not particularly limited, and for example, it can be manufactured as follows. First, a laminate in which the first and second copper plates 4 and 4' are arranged on the front and back surfaces of the ceramic sintered body 3 is formed. Next, the laminate is heated for about 10 minutes under nitrogen atmosphere conditions of 1070 degrees C to 1075 degrees C. As a result, a Cu-O eutectic liquid phase is generated at the interface where the ceramic sintered body 3 and the first and second copper plates 4 and 4' are bonded (hereinafter, collectively referred to as "bonding interface"), and the front and back surfaces of the ceramic sintered body 3 get wet. Next, the Cu-O eutectic liquid phase is solidified by cooling the laminate, and the first and second copper plates 4 and 4' are bonded to the ceramic sintered body 3.
The first bonding material 5 is arranged between the first copper plate 4 and the semiconductor chip 6. The semiconductor chip 6 is bonded to the first copper plate 4 via the first bonding material 5. The bonding wire 7 connects the semiconductor chip 6 and the first copper plate 4.

The second bonding material 5' is arranged between the second copper plate 4' and the heat sink 8. The heat sink 8 is bonded to the second copper plate 4' via the second bonding material 5'. The heat sink 8 can be constituted of copper or the like, for example.

(Structure of ceramic sintered body 3)

The ceramic sintered body 3 contains Al (aluminum), Zr (zirconium), Y (yttrium), and Mg (magnesium).
The contents of the constituent elements of the ceramic sintered body 3 are as follows.

- Zr: 7.5 mass% or more and 23.5 mass% or less in terms of $ZrO_2$
- Al: 74.9 mass% or more and 91.8 mass% or less in terms of $Al_2O_3$
- Y: 0.41 mass% or more and 1.58 mass% or less in terms of $Y_2O_3$
- Mg: 0.10 mass% or more and 0.80 mass% or less in terms of MgO

It is considered that by setting the Zr content to 7.5 mass% or more in terms of $ZrO_2$, it is possible to prevent the linear thermal expansion coefficient $\alpha$ of the ceramic sintered body 3 from becoming too small, and it is possible to reduce the difference in the linear thermal expansion coefficient of the ceramic sintered body 3 and the first and second circuit plates 4 and 4'. As a result, it is considered that the thermal stress generated at the bonding interface can be reduced, so that it contributes to prevent cracks from occurring due to the thermal cycle.
It is considered that by setting the Zr content to 23.5 mass% or less in terms of $ZrO_2$, an excessive reaction at the bonding interface at the time of circuit plate bonding can be prevented. As a result, it is considered that it contributes to prevent voids from occurring at the bonding interface.
It is considered that by setting the Y content to 0.41 mass% or more in terms of $Y_2O_3$, it is possible to prevent the M phase ratio from becoming excessive after thermal aging which will be described later. As a result, it is considered that the thermal aging treatment contributes to prevent the mechanical strength of the ceramic sintered body 3 from decreasing.
It is considered that by setting the Y content to 1.58 mass% or less in terms of $Y_2O_3$, it is considered that it is possible to prevent the M phase ratio from becoming too small after thermal aging which will be described later. As a result, it is considered that the thermal aging treatment contributes to prevent the mechanical strength of the ceramic sintered body 3 from decreasing.
It is considered that by setting the Mg content to 0.10 mass% or more in terms of MgO, the ceramic sintered body 3 can be sintered without excessively raising the firing temperature, and the coarsening of $Al_2O_3$ particles and $ZrO_2$ particles is prevented. As a result, it is considered that the mechanical strength of the ceramic sintered body 3 can be improved, so that it contributes to prevent cracks from occurring due to the thermal cycle. Further, it is considered that a sufficient amount of $MgAl_2O_4$ (spinel) crystals can be generated in the ceramic sintered body 3, and the wettability with the Cu-O eutectic liquid phase at the time of bonding the circuit plate can be improved. As a result, it is considered that it contributes to prevent voids from occurring at the bonding interface.
It is considered that by setting the Mg content to 0.80 mass% or less in terms of MgO, an excessive growth of alumina crystals and zirconia crystals can be prevented, and the mechanical strength of the ceramic sintered body 3 can be improved. As a result, it is considered that it contributes to prevent cracks from occurring due to the thermal cycle. Further, it is considered that an excessive formation of $MgAl_2O_4$ crystals in the ceramic sintered body 3 can be prevented, and an excessive reaction at the bonding interface at the time of circuit plate bonding can be prevented. As a result, it is considered that it contributes to prevent voids from occurring at the bonding interface.
Although in the present embodiment, the content of the constituent elements of the ceramic sintered body 3 is calculated in terms of oxide as described above, the constituent elements of the ceramic sintered body 3 may or may not exist in the form of oxide. For example, at least one of Y, Mg and Ca may not exist in the form of an oxide and may be dissolved in $ZrO_2$.
Note that the content of the constituent elements of the ceramic sintered body 3 in terms of oxide is calculated as follows. First, the constituent elements of the ceramic sintered body 3 are qualitatively analyzed using an energy dispersive analyzer (EDS) attached to a fluorescent X-ray analyzer (XRF) or a scanning electron microscope (SEM). Next, each element detected by this qualitative analysis is quantitatively analyzed using an ICP emission spectroscopic analyzer. Next, the content of each element measured by this quantitative analysis is converted into an oxide.
In addition to the above-mentioned constituent elements, the ceramic sintered body 3 may contain at least one oxide of Hf (hafnium), Si (silicon), Ca (calcium), Na (sodium), K (potassium), Fe (iron), Ti (titanium) and Mn (manganese). These oxides may be intentionally added or may be unavoidably mixed.

(M phase ratio of ceramic sintered body 3)

The ceramic sintered body 3 contains a $ZrO_2$ crystal phase as a crystal phase. The $ZrO_2$ crystal phase has a monoclinic phase and a tetragonal phase as crystal structures.

In the X-ray diffraction pattern of the ceramic sintered body 3 which is thermally aged for 100 hours in an environment of 180 degrees C after sintering, the ratio of peak intensities (hereinafter referred to as "M phase ratio after thermal aging") of the monoclinic phase with respect to the sum of the peak intensities of the monoclinic phase and the tetragonal phase is 15% or less. As a result, it is considered that in the ceramic sintered body 3, it is possible to prevent defects from accumulating due to the stress strain associated with the volume expansion caused by the phase transition of the tetragonal phase of the zirconia crystal to the monoclinic phase.

The M phase ratio after thermal aging is preferably 4% or more. As a result, it is considered that the tetragonal phase of the zirconia crystal undergoes a phase transition to the monoclinic phase at the tip of the crack generated when mechanical stress is applied to the ceramic sintered body 3, and it is possible to prevent cracks from propagating. As a result, it is considered that it contributes to prevent the mechanical strength of the ceramic sintered body 3 after the thermal aging from decreasing.

Further, in the X-ray diffraction pattern of the ceramic sintered body 3 which has not been subjected to the thermal aging treatment, the ratio of the peak intensity of the monoclinic phase to the sum of the peak intensities of each of the monoclinic phase and the tetragonal phase (hereinafter, "The M phase ratio before thermal aging") is preferably 7% or less. As a result, it is considered that it is possible to prevent the phase transition of the tetragonal phase of the zirconia crystal to the monoclinic phase during thermal aging, and further prevent a decrease of the mechanical strength of the ceramic sintered body 3 after thermal aging.

Note that the M phase ratio before and after thermal aging can be calculated using an X-ray diffraction pattern obtained by analyzing the outer surface of the ceramic sintered body 3 with an X-ray diffractometer (XRD: MiniFlexII manufactured by Rigaku Corporation) from the following formula (1). In the formula (1), M1 is the peak intensity of the monoclinic (111) plane, M2 is the peak intensity of the monoclinic (11-1) plane, T1 is the peak intensity of the tetragonal (111) plane, and T2 is the peak intensity of the cubic (111) plane.

$$\text{Ratio of monoclinic phase} = 100 \times (M1 + M2) / (T1 + T2 + M1 + M2) \cdots (1)$$

The M phase ratio after thermal aging can be easily adjusted by controlling the particle characteristics of the $ZrO_2$ crystal particles contained in the ceramic sintered body 3 after sintering after optimizing the content of the constituent elements of the ceramic sintered body 3 as described above. Specifically, the average particle size of the $ZrO_2$ crystal particles contained in the ceramic sintered body 3 is 0.6 $\mu$m or more and 1.5 $\mu$m or less, and the area ratio of coarse $ZrO_2$ crystal particles among the $ZrO_2$ crystal particles contained in the ceramic sintered body 3 having the particle size of 1.8 $\mu$m or more is 15% or less. Note that the method for controlling the average particle size of the $ZrO_2$ crystal particles and the content ratio of the coarse $ZrO_2$ crystal particles in the ceramic sintered body 3 will be described later.

The average particle size of the $ZrO_2$ crystal particles is calculated as follows. First, the outer surface of the ceramic sintered body 3 is imaged at a magnification of 6000 times using a scanning electron microscope. Next, using image processing software, the average circle-equivalent diameter of 300 $ZrO_2$ crystal particles randomly selected from the captured image is calculated as the average particle size. The average circle-equivalent diameter is the average value of the circle-equivalent diameter, and the circle-equivalent diameter is the diameter of a circle having the same area as the particles.

The area ratio of the coarse $ZrO_2$ crystal particles is a value divided the total area of the coarse $ZrO_2$ crystal particles having a circular equivalent diameter of 1.8 $\mu$m or more among the 300 $ZrO_2$ crystal particles selected for the measurement of the average particle size by the total area of the 300 $ZrO_2$ crystals.

(Spinel phase ratio of ceramic sintered body 3)

The ceramic sintered body 3 may contain the $MgAl_2O_4$ crystal phase as the crystal phase. In this case, in the X-ray diffraction pattern of the ceramic sintered body 3 that has not been subjected to the thermal aging treatment, the ratio of the peak intensity of the $MgAl_2O_4$ crystal phase to the peak intensity of the $Al_2O_3$ crystal phase (hereinafter referred to as "spinel phase ratio") is preferably 4% or less. As a result, it is possible to prevent an excessive reaction at the bonding interface at the time of copper plate bonding, so that it is possible to prevent voids from occurring at the bonding interface. Note that the spinel phase ratio may be 0%.

The spinel phase ratio is more preferably 0.5% or more and 3.5% or less. As a result, the wettability between the ceramic sintered body 3 and the Cu-O eutectic liquid phase at the time of copper plate bonding can be improved, and the excessive reaction at the bonding interface at the time of copper plate bonding can be further prevented. It is possible to further prevent voids from occurring at the bonding interface.

The spinel phase ratio can be obtained from the following formula (2) using an X-ray diffraction pattern obtained by analyzing the surface of the ceramic sintered body 3 with XRD. In the formula (2), A1 is the peak intensity of the (311) plane of the spinel phase, and B1 is the peak intensity of the (104) plane of the $Al_2O_3$ crystal phase.

$$\texttt{Ratio of MgAl}_2\texttt{O}_4 \ (\%) \ = \ 100 \ \texttt{x A1} \ / \ (\texttt{A1 + B1}) \ ...(2)$$

(Manufacturing method of ceramic sintered body 3)

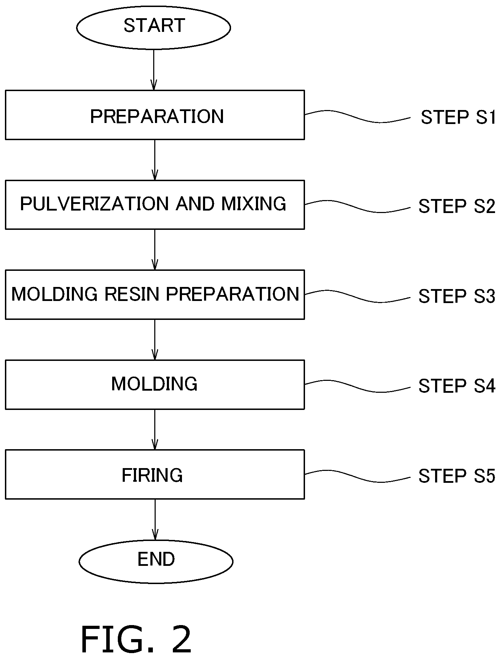

With reference to FIG. 2, a method for manufacturing the ceramic sintered body 3 will be described. FIG. 2 is a flowchart showing a method for manufacturing the ceramic sintered body 3.

In step S1, the following powder materials are prepared.

- $ZrO_2$ of 7.5 mass% or more and 23.5 mass% or less in terms of $ZrO_2$
- $Al_2O_3$ of 74.9 mass% or more and 91.8 mass% or less in terms of $Al_2O_3$
- $Y_2O_3$ of 0.41 mass% or more and 1.58 mass% or less in terms of $Y_2O_3$
- MgO of 0.10 mass% or more and 0.80 mass% or less in terms of MgO

At this time, it is preferable to use $ZrO_2$ powder having a specific surface area of 5 $m^2$/g or more and 10 $m^2$/g. This makes it easier to prevent cracks from occurring due to the thermal cycle.

Note that each of $ZrO_2$ and $Y_2O_3$ may be a single powder material or $ZrO_2$ powder partially stabilized with $Y_2O_3$ in advance. Further, if desired, powder materials such as $HfO_2$, $SiO_2$, CaO, $Na_2O$ and $K_2O$ may be blended.

In step S2, the prepared powder material is pulverized and mixed by, for example, a ball mill.

In step S3, an organic binder (for example, polyvinyl butyral), a solvent (xylene, toluene, or the like) and a plasticizer (dioctyl phthalate) are added to the pulverized and mixed powder material to form a slurry-like substance.

In step S4, the slurry-like substance is molded into a desired shape by a desired molding means (for example, mold press, cold hydrostatic press, injection molding, doctor blade method, extrusion molding method, or the like) to form a ceramic molded product.

In step S5, the ceramic sintered body 3 is formed by firing the ceramic molded body in an oxygen atmosphere or an atmospheric atmosphere (1580 degrees C to 1620 degrees C, 0.7 hours to 1.0 hours). As described above, in this ceramic sintered body 3, the average particle size of the $ZrO_2$ crystal particles after sintering is 0.6 $\mu$m or more and 1.5 $\mu$m or less, and the area ratio of the coarse $ZrO_2$ crystal particles is 15% or less, so that it is possible to prevent the mechanical strength from decreasing due to the thermal aging treatment. Further, as described above, the content of each constituent element in the ceramic sintered body 3 is optimized and the ceramic sintered body 3 is produced by using $ZrO_2$ powder having a specific surface area of 5 $m^2$/g or more and 10 $m^2$/g, so that it is possible to prevent cracks from occurring by the thermal cycle.

Note that the average particle size of the $ZrO_2$ crystal particles and the content ratio of the coarse $ZrO_2$ crystal particles in the ceramic sintered body 3 can be adjusted to some extent by controlling the composition of the powder material (step S1), the pulverization and mixing time (step S2), and the firing temperature (step S5). When the pulverization and mixing time is lengthened, the average particle size of the $ZrO_2$ crystal particles tends to decrease and the content ratio of the coarse $ZrO_2$ crystal particles also tends to decrease. When the firing temperature is raised, the average particle size of the $ZrO_2$ crystal particles tends to increase and the content ratio of the coarse $ZrO_2$ crystal particles also tends to increase.

(Features)

In the ceramic sintered body 3, the Zr content is 7.5 mass% or more and 23.5 mass% or less in terms of $ZrO_2$, and the Al content is 74.9 mass% or more and 91.8 mass% or less in terms of $Al_2O_2$, the Y content is 0.41 mass% or more and 1.58 mass% or less in terms of $Y_2O_3$, and the Mg content is 0.10 mass% or more and 0.80 mass% or less in terms of MgO. The M phase ratio after thermal aging is 15% or less.

In this way, by optimizing the content of the constituent elements of the ceramic sintered body 3 and setting the M phase ratio after thermal aging to 15% or less, the mechanical strength (flexural strength measured in the three-point bending strength test) after the thermal aging treatment can be maintained, and the occurrence of cracks due to the thermal cycle can be prevented.

[Example]

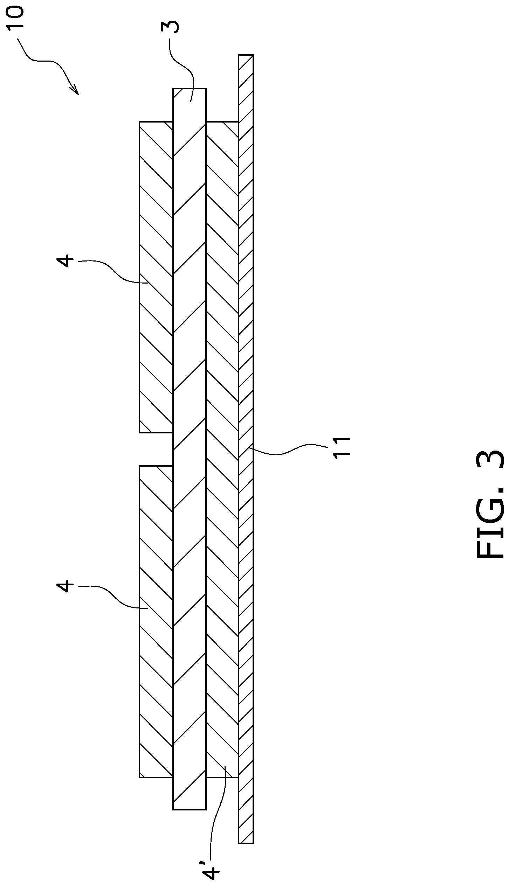

As described below, the ceramic sintered bodies 3 according to Examples 1 to 9 and Comparative Examples 1 to 8 were produced, and the M phase ratio before and after thermal aging and the flexural strength (mechanical strength) before and after thermal aging were measured. Further, the ceramic sintered bodies 3 according to Examples 1 to 9 and Comparative Examples 1 to 8 are used to prepare a substrate sample 10 for a semiconductor device illustrated in FIG. 3, and the number of thermal cycles which causes cracks in the ceramic sintered body 3 was measured.

(Preparation of ceramic sintered body 3)

First, the materials having the compositions illustrated in Table 1 were pulverized and mixed by a ball mill. In Examples 1 to 9 and Comparative Examples 1 to 6, $ZrO_2$ powder having a specific surface area of 5 $m^2$/g or more and 10 $m^2$/g or less was used, and in Comparative Examples 7 and 8, $ZrO_2$ powder having the specific surface area was 13 $m^2$/g or more and 19 $m^2$/g or less was used.

Next, polyvinyl butyral as an organic binder, xylene as a solvent, and dioctyl phthalate as a plasticizer were added to the pulverized and mixed powder material to form a slurry-like substance.

Next, a ceramic molded body was produced by molding a slurry-like substance into a sheet by the doctor blade method.

Next, the ceramic molded product was fired in an air atmosphere at the firing temperature illustrated in Table 1 for 0.8 hours to prepare a ceramic sintered body 3. The size of the ceramic sintered body 3 was 0.32 mm in thickness, 39 mm in length, and 45 mm in width.

(M phase rate)

Using the X-ray diffraction pattern obtained by analyzing the outer surface of each ceramic sintered body 3 after sintering with XRD (MiniFlexII manufactured by Rigaku Corporation), the M phase ratio before thermal aging was calculated from the above formula (1). The calculated M phase ratio before thermal aging is summarized in Table 1.

Subsequently, each ceramic sintered body 3 after sintering was subjected to a thermal aging treatment for 100 hours in an environment of 180 degrees C.

Next, using the X-ray diffraction pattern obtained by analyzing the outer surface of each ceramic sintered body 3 after thermal aging with XRD (MiniFlexII manufactured by Rigaku Corporation), the M phase ratio after thermal aging was calculated from the above formula (1). The calculated M phase ratio after thermal aging is summarized in Table 1.

(Spinel phase rate)

Using the X-ray diffraction pattern obtained by analyzing the outer surface of each ceramic sintered body 3 after sintering with XRD (MiniFlexII manufactured by Rigaku Corporation), the ratio of the peak intensity of the $MgAl_2O_4$ crystal phase (spinel phase ratio before thermal aging) to the peak intensity of the $Al_2O_3$ crystal phase was calculated from the above formula (2). The calculated spinel phase ratio before thermal aging is summarized in Table 1.

(Flexural strength)

The flexural strength (mechanical strength) of 10 pieces of each ceramic sintered body 3 after sintering was measured by a three-point bending strength test of sample size (15 × 45 × thickness 0.32 mm) and span of 30 mm, and the arithmetic mean value (flexural strength before thermal aging) of the measured values of 10 pieces was calculated. The flexural strength before thermal aging is summarized in Table 1.

Subsequently, each ceramic sintered body 3 after sintering was subjected to a thermal aging treatment for 100 hours in an environment of 180 degrees C.

Next, the flexural strength (mechanical strength) of 10 pieces for each ceramic sintered body 3 after thermal aging was measured by a three-point bending strength test of sample size (15 × 45 × thickness 0.32 mm) and span of 30 mm, and the arithmetic mean value (flexural strength after thermal aging) of the measured values of 10 pieces was calculated. The flexural strength after thermal aging is summarized in Table 1.

(Preparation of substrate sample 10 for a semiconductor device)

By heating the first and second copper plates 4, 4'(each having a thickness of 0.40 mm) constituted of oxygen-free copper conforming to JIS C1020 to 300 degrees C in the atmosphere, each outer surface of the first and second copper plates 4, 4' was oxidized.

Next, the laminated body in which the ceramic sintered bodies 3 according to Examples 1 to 9 and Comparative Examples 1 to 8 are sandwiched between the first and second copper plates 4, 4' is placed on the mesh material 11 constituted of Mo (molybdenum) and heated at 1070 degrees C for 10 minutes in a nitrogen ($N_2$) atmosphere.

Next, by cooling the laminated body, the first and second copper plates 4, 4' were bonded to the ceramic sintered body 3, and the mesh material 11 was bonded to the second copper plate 4'.

(Crack occurrence rate)

For each substrate sample 10 for a semiconductor device, the thermal cycle of "room temperature for 5 minutes and 310 degrees C for 5 minutes" was repeated in an atmosphere of a mixed gas ($N_2$:$H_2$ = 7:3) of $N_2$ (nitrogen) and $H_2$ (hydrogen) until cracks occur in the ceramic sintered body 3.

In Table 1, the number of thermal cycles in which cracks occur in any of the 10 pieces of each ceramic sintered body 3 is listed as the number of crack occurrence thermal cycles. In Table 1, samples with 20 or more crack occurrence thermal cycles are evaluated as "⊚", samples with 7 or more and 19 or less times are evaluated as "○", and samples with 6 or less times are evaluated as "x".

[Table 1]

| | Composition (mass%) | | | | | | Firing temperature (degrees C) | Characteristics | | | | | | | | | | |
| | | | | | | | | Ceramic sintered body | | | | | | | | | Substrate for semiconductor device | |
| | | | | | | | | ZrO₂ crystal grain | | Before thermal aging | | | After thermal aging | | | Number of crack generation thermal cycles | |
| | $Al_2O_3$ | $ZrO_2$ | $Y_2O_3$ | To $ZrO_2$ | MgO | Total | | Avarage grain size | 1.8μm or more | M phase rate | Spinel phase rate | Flexural strength | M phase rate | Flexural strength | | | |
| | | | | | | | | (μm) | (%) | (%) | (%) | (MPa) | (%) | (MPa) | Evaluaion | Times | Evaluaion |
| Example 1 | 89.2 | 10 | 0.54 | 5.4 | 0.30 | 100 | 1600 | 0.8 | 5 | 2 | 2 | 600 | 4 | 580 | ○ | 15 | ○ |
| Example 2 | 81.3 | 17.5 | 0.95 | 5.4 | 0.30 | 100 | 1600 | 0.9 | 7 | 5 | 2 | 670 | 8 | 650 | ○ | 25 | ◎ |
| Example 3 | 78.6 | 20 | 1.08 | 5.4 | 0.30 | 100 | 1600 | 0.9 | 7 | 6 | 2 | 700 | 6 | 690 | ○ | 30 | ◎ |
| Example 4 | 91.8 | 7.5 | 0.41 | 5.4 | 0.30 | 100 | 1600 | 0.8 | 6 | 6 | 2 | 570 | 10 | 520 | ○ | 8 | △ |
| Example 5 | 74.9 | 23.5 | 1.27 | 5.4 | 0.30 | 100 | 1600 | 0.9 | 9 | 5 | 2 | 730 | 11 | 710 | ○ | 20 | ◎ |
| Example 6 | 78.8 | 20 | 0.90 | 4.5 | 0.30 | 100 | 1600 | 0.7 | 4 | 7 | 3 | 690 | 14 | 640 | ○ | 9 | △ |
| Example 7 | 78.1 | 20 | 1.58 | 7.9 | 0.30 | 100 | 1600 | 0.8 | 7 | 3 | 2 | 600 | 7 | 500 | ○ | 7 | △ |
| Example 8 | 78.8 | 20 | 1.08 | 5.4 | 0.10 | 100 | 1620 | 1.3 | 12 | 6 | 0 | 670 | 10 | 650 | ○ | 14 | ○ |
| Example 9 | 78.2 | 20 | 1.08 | 5.4 | 0.75 | 100 | 1580 | 1.4 | 12 | 5 | 5 | 660 | 10 | 640 | ○ | 13 | △ |
| Comparative Example 1 | 94.4 | 5 | 0.27 | 5.4 | 0.30 | 100 | 1600 | 0.9 | 8 | 4 | 1 | 550 | 7 | 520 | ○ | 2 | × |
| Comparative Example 2 | 73.4 | 25 | 1.35 | 5.4 | 0.30 | 100 | 1600 | 0.8 | 9 | 1 | 4 | 750 | 10 | 690 | ○ | 6 | × |
| Comparative Example 3 | 91.9 | 7.5 | 0.27 | 3.6 | 0.30 | 100 | 1600 | 0.7 | 8 | 5 | 3 | 620 | 30 | 430 | × | 5 | × |
| Comparative Example 4 | 74.1 | 23.5 | 2.07 | 8.8 | 0.30 | 100 | 1600 | 0.9 | 8 | 4 | 2 | 490 | 3 | 480 | × | 6 | × |
| Comparative Example 5 | 78.9 | 20 | 1.08 | 5.4 | 0.05 | 100 | 1620 | 1.7 | 17 | 9 | 0 | 640 | 20 | 570 | ○ | 3 | × |
| Comparative Example 6 | 77.9 | 20 | 1.08 | 5.4 | 1.00 | 100 | 1580 | 1.5 | 15 | 7 | 5 | 630 | 12 | 590 | ○ | 5 | × |

| | Composition (mass%) | | | | | | Firing temperature (degrees C ) | Characteristics | | | | | | | | | | |
|---|---|---|---|---|---|---|---|---|---|---|---|---|---|---|---|---|---|---|
| | | | | | | | | Ceramic sintered body | | | | | | | | | Substrate for semiconductor device | |
| | | | | | | | | ZrO$_2$ crystal grain | | Before thermal aging | | | After thermal aging | | | Number of crack generation thermal cycles | |
| | Al$_2$O$_3$ | ZrO$_2$ | Y$_2$O$_3$ | To ZrO$_2$ | MgO | Total | | Avarage grain size | 1.8$\mu$m or more | M phase rate | Spinel phase rate | Flexural strength | M phase rate | Flexural strength | | | |
| | | | | | | | | ($\mu$m) | (%) | (%) | (%) | (MPa) | (%) | (MPa) | Evaluaion | Times | Evaluaion |
| Comparative Example 7 | 89.2 | 10 | 0.54 | 5.4 | 0.30 | 100 | 1560 | 0.8 | 10 | 5 | 3 | 600 | 25 | 480 | × | 3 | × |
| Comparative Example 8 | 78.6 | 20 | 1.08 | 5.4 | 0.30 | 100 | 1560 | 0.8 | 8 | 7 | 3 | 660 | 23 | 620 | ○ | 3 | × |

EP 3 854 767 A1

As illustrated in Table 1, in the ceramic sintered body 3 using ZrO$_2$ powder having a specific surface area of 5 m$^2$/g or more and 10 m$^2$/g or less, the content of constituent elements is optimized as follows and in Examples 1 to 9 in which the M phase ratio after thermal aging was 15% or less, both maintenance of mechanical strength after the thermal aging treatment and prevention of cracks by the thermal cycle could be achieved at the same time. Specifically, in Examples 1 to 9, the flexural strength after thermal aging was 500 MPa or more, and the number of crack occurrence thermal cycles was 7 or more.

• ZrO$_2$ of 7.5 mass% or more and 23.5 mass% or less in terms of ZrO$_2$

- • Al$_2$O$_3$ of 74.9 mass% or more and 91.8 mass% or less in terms of Al$_2$O$_3$
- • Y$_2$O$_3$ of 0.41 mass% or more and 1.58 mass% or less in terms of Y$_2$O$_3$
- • MgO of 0.10 mass% or more and 0.80 mass% or less in terms of MgO

On the other hand, in Comparative Examples 1 to 6, the content of the constituent elements was not optimized, and in Comparative Examples 7 and 8, the M phase ratio after thermal aging was more than 15%, so that both maintenance of mechanical strength and prevention of cracks could not be achieved at the same time.

INDUSTRIAL APPLICABILITY

According to the present invention, it is possible to prevent the mechanical strength from decreasing and cracks from occurring in the ceramic sintered body, so that the ceramic sintered body according to the present invention can be used for a substrate for a semiconductor device used in various electronic devices.

REFERENCE SIGNS LIST

| 1 | Semiconductor device |
| 2 | Substrate for semiconductor device |
| 3 | Ceramic sintered body |
| 4, 4' | Copper plate |
| 5, 5' | Bonding material |
| 6 | Semiconductor chip |
| 7 | Bonding wire |
| 8 | Heat sink |
| 10 | Substrate sample for semiconductor device |
| 11 | Mesh material |

**Claims**

1. A ceramic sintered body containing Zr, Al, Y, and Mg, wherein
a Zr content is 7.5 mass% or more and 23.5 mass% or less in terms of ZrO$_2$,
an Al content is 74.9 mass% or more and 91.8 mass% or less in terms of Al$_2$O$_3$,
a Y content is 0.41 mass% or more and 1.58 mass% or less in terms of Y$_2$O$_3$,
a Mg content is 0.10 mass% or more and 0.80 mass% or less in terms of MgO, and
a ZrO$_2$ crystal phase as a crystal phase has a monoclinic phase and a tetragonal phase as crystal structures, and when a thermal aging treatment is performed for 100 hours in an environment of 180 degrees C, a ratio of a peak intensity of the monoclinic phase to a sum of peak intensities of the monoclinic phase and the tetragonal phase is 15% or less in the X-ray diffraction pattern.

2. The ceramic sintered body according to claim 1, wherein
when a thermal aging treatment is performed for 100 hours in an environment of 180 degrees C, a ratio of a peak intensity of a monoclinic phase to a sum of peak intensities of a monoclinic phase and a tetragonal phase is 4% or more in the X-ray diffraction pattern.

3. The ceramic sintered body according to claim 1 or 2 containing an Al$_2$O$_3$ crystal phase and an MgAl$_2$O$_4$ crystal phase as crystal phases, wherein
before the thermal aging treatment, a ratio of a peak intensity of the MgAl$_2$O$_4$ crystal phase to a peak intensity of

the $Al_2O_3$ crystal phase in the X-ray diffraction pattern is 4% or less.

4. The ceramic sintered body according to any one of claims 1 to 3, wherein
when a thermal aging treatment is performed for 100 hours in an environment of 180 degrees C, a bending strength is 500 MPa or more.

5. The ceramic sintered body according to any one of claims 1 to 4,
before the thermal aging treatment, in the X-ray diffraction pattern, a ratio of a peak intensity of a monoclinic phase to a sum of peak intensities of each of a monoclinic phase and a tetragonal phase is 7% or less.

FIG. 1

FIG. 2

FIG. 3

<table>
<tr><td colspan="2">**INTERNATIONAL SEARCH REPORT**</td><td colspan="2">International application No.<br>PCT/JP2018/044950</td></tr>
</table>

A. CLASSIFICATION OF SUBJECT MATTER
Int.Cl. C04B35/119(2006.01)i, H01L23/15(2006.01)i

According to International Patent Classification (IPC) or to both national classification and IPC

B. FIELDS SEARCHED

Minimum documentation searched (classification system followed by classification symbols)
Int.Cl. C04B35/119, H01L23/15

Documentation searched other than minimum documentation to the extent that such documents are included in the fields searched
Published examined utility model applications of Japan     1922–1996
Published unexamined utility model applications of Japan   1971–2019
Registered utility model specifications of Japan           1996–2019
Published registered utility model applications of Japan   1994–2019

Electronic data base consulted during the international search (name of data base and, where practicable, search terms used)
JSTPlus/JSTChina/JST7580(JDreamIII)

C. DOCUMENTS CONSIDERED TO BE RELEVANT

| Category* | Citation of document, with indication, where appropriate, of the relevant passages | Relevant to claim No. |
|---|---|---|
| A | WO 2014/103465 A1 (NIKKO KK) 03 July 2014, entire text<br>(Family: none) | 1–5 |
| A | WO 2017/217490 A1 (NGK INSULATORS LTD.) 21 December 2017, entire text<br>& CN 108025982 A | 1–5 |
| A | JP 1-212273 A (HITACHI CHEMICAL CO., LTD.) 25 August 1989, entire text<br>(Family: none) | 1–5 |

☒   Further documents are listed in the continuation of Box C.     ☐   See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>16.01.2019 | Date of mailing of the international search report<br>29.01.2019 |
|---|---|
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

International application No.

PCT/JP2018/044950

C (Continuation).    DOCUMENTS CONSIDERED TO BE RELEVANT

| Category* | Citation of document, with indication, where appropriate, of the relevant passages | Relevant to claim No. |
|---|---|---|
| A | JP 57-140371 A (MITSUBISHI METAL CORP.) 30 August 1982, entire text (Family: none) | 1-5 |
| A | JP 57-100976 A (SUMITOMO ELECTRIC INDUSTRIES, LTD.) 23 June 1982, entire text (Family: none) | 1-5 |

Form PCT/ISA/210 (continuation of second sheet) (January 2015)

**EP 3 854 767 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4717960 B
- JP 2015534280 A
- WO 2016208766 A